# EUROPEAN PATENT SPECIFICATION

(11) **EP 2 095 428 B1**
(45) Date of publication and mention of the grant of the patent: **02.02.2011**
(21) Application number: 07817971.0
(22) Date of filing: 23.11.2007
(51) Int. Cl.: H01L 31/0352, H01L 31/0304, H01L 33/00

(54) **AN OPTICAL DEVICE**
OPTISCHE ANORDNUNG
DISPOSITIF OPTIQUE

(30) Priority: 06.12.2006 US 868826 P
(43) Date of publication of application: 02.09.2009
(73) Proprietor: SunFlake A/S, 2100 København Ø (DK)
(72) Inventor: AAGESEN, Martin, 2640 Hedehusene (DK)
(74) Representative: Johnson, Richard Alan
(86) International application number: PCT/DK2007/050175
(87) International publication number: WO 2008/067824

(56) References cited:
- WO-A-03/028118
- WO-A1-99/50916
- US-A1- 2007 160 747

## Description

### FIELD OF THE INVENTION

The present invention relates to an optical device and to a method of fabricating the same, moreover the invention relates to a photovoltaic device, a radiation detector and a light emitting.device.

### BACKGROUND OF THE INVENTION

Solar energy has long been considered as a potential candidate of energy source to participate in the replacement of fossil fuels as the main energy source. However, widespread application of solar energy has to date been hampered by a somewhat limited efficiency of solar cells or photovoltaic cells, typically not much better than 20%, combined with a relative high production cost. Therefore, currently, solar cells are primarily used where conventionally generated energy is unavailable or where the cost of bringing conventional energy to the location more closely match the production cost of solar cells.

Current photovoltaic cells often employ thin layers of semiconductor material, e.g. crystalline silicon, gallium arsenide, or the like, incorporating an np-junction to convert photo-induced energy to direct current. While current photovoltaic cells steadily increase in efficiency, it is generally believed that the physical properties of these devices will limit the efficiency to around 30%.

Fine tuning of current types of photovoltaic cells is expensive in terms of development costs and moreover since the maximal achievable efficiency is believed to be limited, a direct improvement of current technology does not seem to be the proper strategy of providing a solar cell suitable for widespread use as an alternative to fossil fuels or other conventional energy sources. In a promising alternative, solutions have been proposed relating to photovoltaic cells based on microsized or nanosized semiconducting structures as the active element.

The US patent 7,087,833 discloses a photovoltaic device that includes semiconductor nanostructures as at least a portion of a photoactive layer. A first and a second population of nanostructures which are made from different materials are provided, the two populations of nanostructures exhibit a type II band offset energy profile with respect to each other.

There is a need in the art for providing improved photovoltaic devices, and in general there is a need to provide improved optical devices, and in particular devices having a high efficiency-cost ratio would be advantageous.

Document WO03/028118 describes en optical device including some mono-structures.

### SUMMARY OF THE INVENTION

The present invention seeks to provide an improved optical device, and it may be seen as an object of the invention to provide a new optical device incorporating nanosized or microsized semiconducting structures in the, or as the, active element, and in particular such devices having a high efficiency-cost ratio.

It is a further object of the present invention to provide an alternative to the prior art.

Thus, the above described object and several other objects are intended to be obtained in a first aspect of the invention by providing an optical device as recited in claim 1. Further adventageous embodiments are recited in the dependent claims.

The first and the second electrode may be made from any suitable electrical conducting material capable of providing an electrical connection from the outside to the active element.

The transparency of the first or the second electrodes may be in the range of 50% to 100%, such as 75% to 90%. In principle, the higher the transparency the better, since it is optimal to maximize the intensity of the incoming radiation. The first wavelength range may be in a range from ultraviolet light to infrared light, such as a range from approximately 200 nm up to approximately 3.5 µm. The first wavelength range may span the entire range or be adapted to span one or more given sub-ranges. The first range may also be set up so that radiation In one or more specific ranges is blocked. The specific ranges provided may be tuned to the specific application of the device, or may be dictated by a specific design choice, including a specific material choice.

The functioning of the active element is at least to separate electron-hole pairs created in a process of interactions between the semiconducting structure and the incoming radiation, such as a photo-induced process. In an alternative embodiment of the active element, electron-hole pairs are injected into the semiconducting structure where they recombine resulting in the creation of radiation which is coupled out of the active element.

At least a plurality of the semiconducting structures is of a specific geometrical shape, the plurality of the semiconducting structures is of a general plate shape, the structures may be of a flake shape having a general pointing shape. In general reference is made to a plate form or shape as a structure being wider than thick, whereas reference to a flake shape is made as a specific type of plate having a general pointing shape. In general may also sub-populations of semiconducting structures of alternative shapes be present. Depending on the specific growth conditions may a number of alternative shape populations co-exists. Likewise also within a specific type of population, distributions of shapes and sizes may be present. In embodiments it may only be a part of the semiconducting structures which are of a general plate shape. In such embodiment, typically an inner structure is of a general plate shape, and regions have been grown from the inner plate shape structure.

The height of the semiconducting structures may be in the range of few hundred nanometers (nm) up to some micrometers (µm), typically 1 to 25 µm. The widths at the lower half of the semiconducting structures may be in the range of 100 nm to 2 µm, and the thickness may be in the range of 5 nm to 500 nm, typically 25 to 100 nm, such as 30 to 80 nm.

At the lower half of the semiconducting structure, or at least of the part of the semiconducting structure, the width is substantially larger than the thickness. In general the width-to-thickness ratio may be in the range of 1.5 to 500 or even more, such as in the range of 3 to 250, such as in the range of 5 to 100 such as in the range of 10 to 75, such as in the range of 25 to 50. The specific width to thickness ratio may depend upon the specific growth conditions applied. Typically a distribution of the width-to-thickness ratio is obtained, for such a distribution the centre of the distribution may be such that for the width-to-thickness ratio of the central part of the distribution, the width is substantially larger than the thickness.

The semiconducting structure may generally be referred to as a nanostucture having at least one region or characteristic dimension in the nanometer range, here at least the thickness of the semiconducting structure, or at least a part of the semiconducting structure, may be in the nanometer range.

The invention is particularly, but not exclusively, advantageous for providing an optical device with a high efficiency. The high efficiency is believed to be related to the geometry of the semiconducting structure. The dimension of the semiconducting structures give rise to a high probability of created electron-hole pairs are not recombined in the vicinity of the creation, instead they are separated at the electrodes.

By providing a device according to the invention, only a small quantity of expensive material is required. Moreover, due to the overall geometrical shape of the semiconducting structures, most of the incoming radiation are absorbed by a semiconducting structure, and not reflected by the surface, as a consequence an antireflective coating on the active element may be avoided. In embodiments, may an antireflective coating still be provided on the surface of the in-coupling electrode, i.e. on the surface of the first or second electrodes or both electrodes.

The first electrode may be of a substrate on which the semiconducting structures are grown or at least protruding from. The first electrode may be a group V/III semiconductor substrate, a group VI/II semiconductor substrate, a group IV semiconductor substrate or a substrate of an alloy thereof. In specific embodiments may the first electrode be a GaAs or Si substrate.

The first electrode may be a transparent conductor, such as a transparent conducting oxide (TCO), e.g. of indium tin oxide (ITO), a doped oxide such as SnO₂: F, ZnO: B, ZnO:Al, etc. The first electrode may also be of a conducting polymer material.

The first electrode may also be an insulator contacted with a conducting or semiconducting electrode, e.g. a glass substrate coated with a metal layer or a glass substrate coated with a semiconducting material.

The first electrode may be a layered structure, such as a structure having a having a first layer and at least a second layer.

The semiconducting structure may be substantially crystalline, such as substantially monocrystalline or polycrystalline. In general it is advantageous to provide semiconducting structures which are substantially crystalline at least over a length-scale of the structure. Since by providing a substantially crystalline structure only few or even no recombination centres may be present. A higher efficiency may thereby be provided.

The semiconducting structure may be of or at least include a group V/III semiconductor, a group VI/II semiconductor or a group IV semiconductor, or of any combination or alloy of such materials. In specific embodiments, the semiconducting structure may be of or at least include InAs, Si, CdSe, CdTe, InP, CdS, ZnS, ZnO, ZnSe, PbSe, PbS, ZnTe, HgTe, GaN, GaP, GaAs, GaSb, InSb, Ge, AlAs, AlSb or PbTe, or any compounds of such materials, including but not limited to ternary or quaternary compounds.

The semiconducting structure may have an absorbance in the visual range or in the infrared range, or both, of at least 70%, such as at least 80%, such as at least 90%, such as at least 95%, such as at least 98%.

The active element comprises an np-junction. The np-junction may be provided by the individual semiconducting structures, by providing semiconducting structures that comprise an n-region having an n-conductivity and a p-region having a p-conductivity, so that the interface between the regions is forming an np-junction. Such regions may be provided in a number of ways.

In an embodiment, semiconducting structures of a first conductivity are provided, the semiconducting structure is then either in connection with the growth or after the growth doped with a material providing a different second conductivity.

In an embodiment, semiconducting structures of n-conductivity or p-conductivity are provided and onto which a semiconductor material of n-conductivity or p-conductivity are provided, so that the semiconducting structure abuts a region having an n-conductivity or p-conductivity, thereby forming an np-junction in the interface.

In an embodiment, semiconducting structures of n-conductivity or p-conductivity are provided and onto which a semiconductor material of the same conductivity is provided, and onto this a semiconductor material of different conductivity is provided, so that the semiconducting structure comprises or supports a region having n-conductivity and a region having p-conductivity, thereby forming an np-junction in the interface.

Semiconducting structures comprising multiple n-regions having an n-conductivity and multiple p-regions having a p-conductivity may be provided, so that multiple np-junctions are formed. A higher efficiency and/or voltage may be provided by providing multiple np-junctions.

The semiconducting structure may have a first lattice constant and the first electrode may have a second lattice constant or no lattice constant, i.e. not being crystalline at all, the first and second lattice constants being different, i.e. there is a lattice mismatch between the semiconducting structure and the substrate on which it is grown. For example for an InAs structure, the lattice constant of 6.1 Å is different than for a GaAs substrate with a lattice constant of 5.7 Å. In another example, the lattice of the semiconducting structures is not matched to the substrate, since the substrate does not posses a lattice, i.e. it is not crystalline, e.g. a glass substrate. It is an advantage that semiconducting structures may be provided which are not lattice-matched to the substrate on which they are grown, since a great flexibility is provided in the type of substrate that may be used. For example an inexpensive substrate may be used, such as a silicon substrate, e.g. a glass substrate, a polymer substrate, or other standard substrates. The lattice of the semiconducting structure at the interface to the substrate may adapt itself to the surface of the substrate.

The semiconducting structure may have a band gab in a range appropriate for a specific application. In embodiments may the semiconducting structure have a band gab in the range of 0.25 eV to 2 eV. The specific size of the band gab may be tuned by the effective size of the semiconducting structure. For example by selecting or providing an appropriate size of a region of the semiconducting structure, such as an n-type region or a p-type region of an appropriate size, the energy band of the structure may be shifted with respect to energy bands of a bulk structure of the same material. By properly adjusting proper sizes of the semiconducting structure, a specific band gab may thereby be provided.

The second electrode may be a top electrode. The second electrode may be of a transparent conductor material, such as a TCO. Also a transparent conducting polymer may be used. The second electrode may also be an insulator contacted with a conducting or semiconducting electrode, such as a glass electrode coated with a metal layer or a semiconducting layer, of a conducting polymer material, an insulating polymer coated with a conductor, etc.

The second electrode may be a layered substrate having a first layer and at least a second layer.

The active element may comprise a filler element being at least partly transparent in a second wavelength range. The optical properties of the second wavelength range may be selected within the range as specified for the first wavelength range. The filler material may be glass, silicon mono-oxide, silicon di-oxide, a polymer, or any other suitable material. Typically, the filler material is an electrical insulator.

In an advantageous embodiment, the filler material may be an SU-8 based polymer. The chemical name of SU-8 is glycidyl ether of bisphenol A. SU-8 may be a suitable filler material since it has a high chemical resistance, it is compatible with conventional microfabrication techniques, and it is relatively easy and fast to process.

In a second aspect of the invention, there is provided a method of fabricating an optical device as recited in claim 14. Further advantageous embodiments are recited in the dependent claims. ;

The plurality of semiconducting structures may be, or may form part of an active element.

The method may be conducted in connection with molecular beam epitaxy (MBE) or any other method capable of growing micro or nanostructures on a substrate. For example in connection with Metalorganic vapour-phase epitaxy (MOPVE), chemical beam epitaxy (CBE), or similar methods of growing a nanostructure.

Additional steps may be conducted such as a step for depositing a filler material onto the semiconducting structures, a step for the provision of a second electrode, so that the plurality of semiconducting structures may be disposed between and in contact with the second electrode.

A first region of the semiconducting structures may be provided with a first region of a first type of conductivity of either p-type or n-type and wherein at least a second region of the semiconducting structures are provided with a second section of a second conductivity of either p-type or n-type, the first and second regions forming an np-junction.

A first region of the semiconducting structures may be provided by depositing a first material during a growth procedure and wherein the second material is provided by depositing a second material during the growth procedure.

The semiconducting structures may be grown with a first type of conductivity and in later step doped with a material so that a doped region is formed, the doped region being of a second type of conductivity.

The doping may be done by means of a coating step and optionally a heating step.

The doping may be done by injecting dopants into the semiconducting structures, e.g. by means of ion bombardment.

The semiconducting structures may be grown with a first type of conductivity and in later step coated with a material of a second type of conductivity. The interface between the semiconducting structures and the coating is forming the np-junction.

The individual aspects of the present invention may each be combined with any of the other aspects. These and other aspects of the invention will be apparent from the following description with reference to the described embodiments.

### BRIEF DESCRIPTION OF THE FIGURES

Embodiments of the invention will be described, by way of example only, with reference to the drawings, in which
FIG. 1 illustrates a schematic embodiment of a photovoltaic cell;
FIG. 2 is a SEM image showing a plurality of flakes as seen from an inclined view;
FIG. 3 is a SEM image showing a few flakes as seen from a top view;
FIG. 4 is a SEM image showing a single flake together with specific geometric orientations;
FIG. 5 is a SEM image showing a side view of a flake;
FIG. 6 is a TEM image of a top section of a flake together with a close-up TEM image of a section of the flake;
FIG. 7 is a schematic illustration of the growth scenario of the flake growth;
FIGS. 8A to 8C illustrate inclined SEM images of flakes grown at varying growth conditions.
FIGS. 9 to 13 are schematic illustrations of embodiment of flakes having an np-junction;
FIG. 14 illustrates an SEM image of flakes embedded in an SU-8 filler; and
FIG. 15 illustrates a flow diagram of a general procedure of fabricating an optical device.

### DESCRIPTION OF EMBODIMENTS

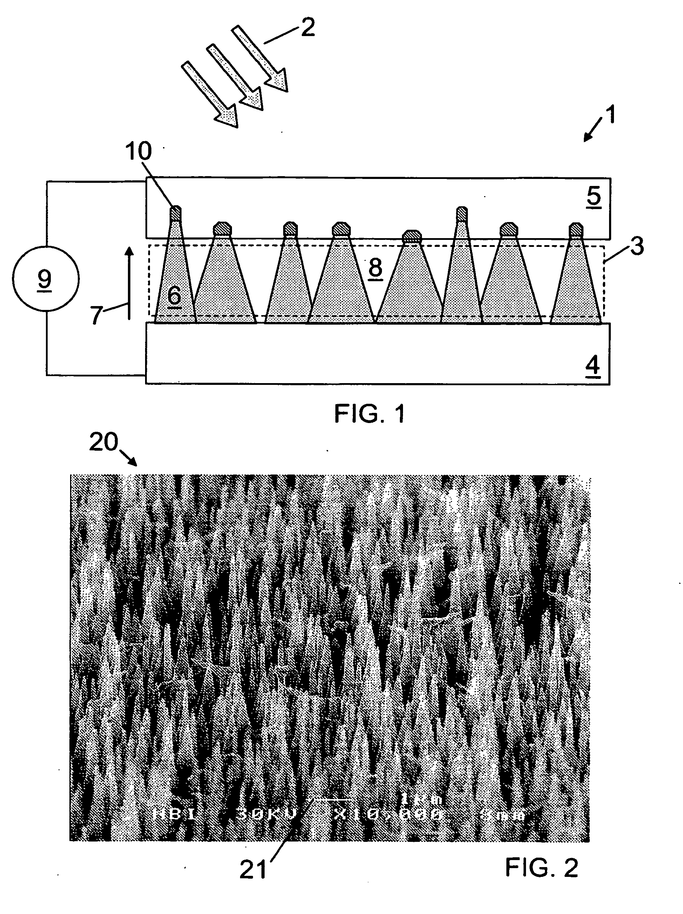

FIG. 1 illustrates a schematic embodiment of an optical device in accordance with the present invention. The illustrated optical device is in the form of a photovoltaic cell 1. In operation, the photovoltaic cell may operate as a solar cell intended to be exposed to radiation 2, such as solar radiation. The radiation is coupled into an active element 3 where electron-hole pairs are created giving rise to an electrical potential 9 which may be exploited for electrical purposes.

The optical device 1 comprises a first electrode or substrate 4 and a second electrode or top electrode 5. Moreover, the device comprises an active element 3 being disposed between the first and second electrodes. In order to couple incoming radiation into the active semiconducting structure, the first or second electrode is at least partly transparent in a first wavelength range. Typically only one of the first or second electrodes is transparent, however both may be transparent.

Moreover, the active element may comprise filler element 8 provided in the regions between the semiconducting structures so as to provide a substantial solid active element. In an alternative embodiment of a general radiation detector, the optical properties of the system may be provided so that a specific wavelength range is detected. An electrical potential between the two electrodes 4, 5 may be indicative or correlated to a specific intensity of incoming radiation of specific optical characteristics.

In another alternative embodiment, a light emitting device such as a LED is provided. In such an embodiment holes are injected at one of the electrodes and electrons are injected at the other electrode, the electron-hole pair being recombined at the np-junction in a radiative recombination process. The generated radiation is coupled out of the active elements.

The active element comprises a plurality or ensemble of semiconducting structures 6 extending in a lengthwise direction 7 from the first electrode and being in contact with the first and second electrodes. The geometrical structure of the semiconducting structures is typically in the general form or shape of a plate, however in embodiments only a part of the semiconducting structure may be of a general plate form or shape. In embodiments the flakes are grown by means of the Vapour-Liquid-Solid (VLS) process, this process is may also be referred to as the Vapour-Solid-Solid (VSS) process due to uncertainty in the specific growth mechanism at the atomic level. In a VLS-process, nucleation centres in the form of catalytic particles, typically metal particles, e.g. gold particles, are deposited or otherwise provided on the substrate before the growth of the semiconducting structures in initiated. Such particles 10 are positioned at a top of the semiconducting structures. Catalytic particles in the form of a metal or another conductor material may ensure a good electrical contact between the semiconducting structures and the top electrode 5.

Embodiments of the growth process are discussed further below.

FIGS. 2 to 5 show SEM images of InAs flakes grown by MBE on a GaAs-substrate. The InAs flakes are grown on the (100) face of a GaAs-substrate. The InAs flakes were grown with a V/III-BEP-ratio of 5.7 using a beam equivalent pressure (BEP) of 1.6×10⁻³Pa (1.2×10⁻⁵ torr) for As₄, and a BEP of 2.8×10⁻⁴ Pa (2.1×10⁻⁶) torr for In. The substrate was held at a temperature of approximate 420 °C and the growth time was 2 hours.

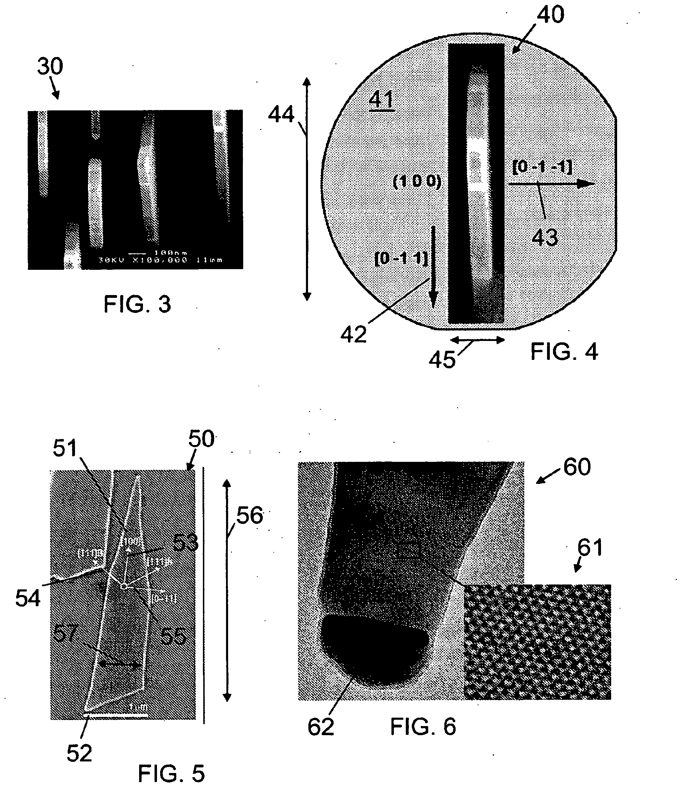

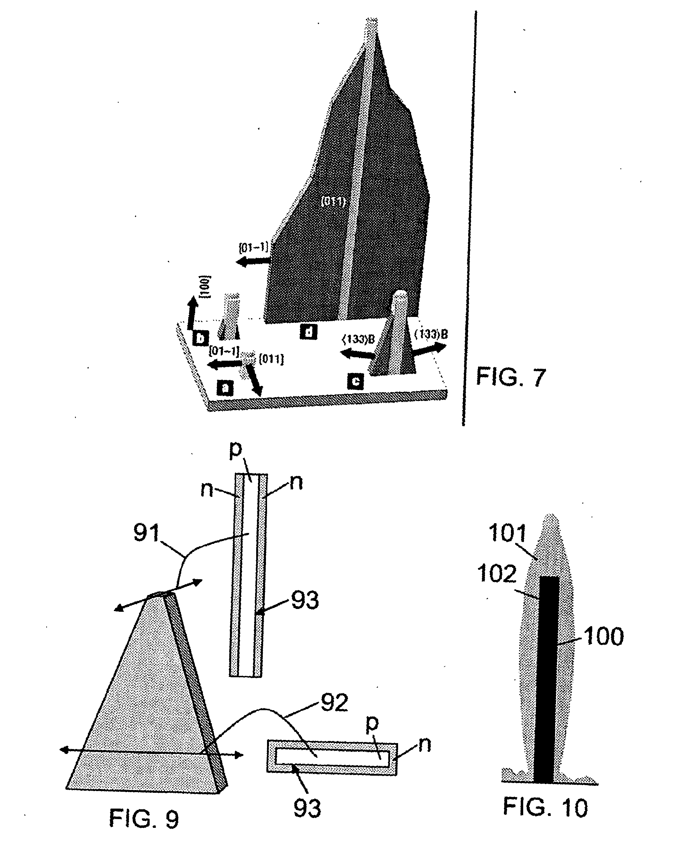

FIG. 2 illustrates a SEM image 20 obtained at 30 KV with a magnification of 10,000. The scale bar 21 indicates the extension of 1 µm. The SEM image 20 shows a plurality of flakes as seen from an inclined view. As can be seen on the image, the majority of the structures are of a general pointed flake shape. However sub-groups of the structures posses deviating shapes. The specific shape is dictated by a number of parameters and many shapes may be similar in overall energy, thus from kinetic considerations alone a single shape may be impossible to provide. However, importantly, a plurality of similar shapes are provided where most, if not all, posses a general plate shape. The shape of the top of the flakes vary, with no single preferred crystal direction, but the sides of the lower part tend to be close to the (0-11) and (01-1) surfaces, as further elaborated upon in connection with FIG. 5 and 7.

FIG. 3 illustrates a SEM image 30 obtained at 30 KV with a magnification of 100,000. The scale bar indicates the extension of 100 nm. The SEM image 30 shows a few flakes as seen from a top view.

FIG. 4 illustrates a SEM image 40 of a single flake. The flake is shown together with the (100) plane, being the plane of the paper. Also the [0-11] direction 42 and the [0-1-1] direction 43 are shown.

FIG. 5 illustrates a SEM image 50 of a flake 51 that have been removed by ultrasound and deposited on a silicon oxide surface. The scale bar 52 indicates the extension of 1 µm. The flake is shown together with the [100] direction 53, the [111] direction 54 and the [0-11] direction 55.

From the FIGS. 2-5 it is clear that the semiconducting structures have heights 56, the heights extending in the lengthwise direction 7, as well as widths 44 extending along the [0-11] direction and thicknesses 45 extending along the [0-1-1] direction. At a section positioned at the lower half of the semiconducting structure, the position being placed e.g. as indicated on FIG. 5 by reference numeral 57, the width to thickness ratio is approximately 1 µm to 80 nm being 12.5. The shown crystal directions are for the system of InAs grown of the (100) face of GaAs. Specific crystal directions depend on specific systems, thus for different semiconducting structures and/or different substrates, different crystal directions may be relevant. The crystal directions are shown for illustrative reasons so as to characterize the illustrated embodiment, the scope of the invention is not limited to specific crystal directions.

FIG. 6 shows a TEM image 60 of the top section of a flake together with a close-up TEM image 61 of a section of the flake. The specific location of the TEM image does not correspond to the indicated one, the specific location is only provided for illustrative reasons. Also an encapsulated gold catalytic particle 62 is shown. From the close-up TEM image showing atomic resolution, it can be seen that the InAs flake is substantially monocrystalline with not more than only a few point defects, if any. Moreover, energy dispersive X-ray analysis (EDX) measurements on the flakes reveal a 50/50 distribution between In and As in the flakes. Diffraction analysis of the flakes reveal that the InAs lattice is unstrained, at least for the majority of the flake.

FIG. 7 is a schematic illustration of the growth mechanism of the flake shape as understood by the time of filing of the present document for InAs flake growth on GaAs(100) in MBE with As₄ as the group V material and In as the group III material. Due to the complex nature of nanoparticle growth, there is some uncertainty related to the growth mechanism. The growth behaviour has been deduced from an investigation of the flake shape as a function of growth time. It is expected that the flake begins with a rod structure having a square cross-section growing in the [100] direction and having the four nonpolar {011} planes as side facets (FIG. 7a). As the growth continues, a small platelet is formed at the intersection between the (100) substrate surface and {011} crystal planes at the base of the rod, but only in the two arsenic-terminated directions (FIG. 7b). This is likely a result of the arsenic incorporation kinetics on (011) and (111)A surfaces. The resulting arsenic-terminated surfaces created on the two sides of the rod crystal are high-energy surfaces with a significantly higher incorporation coefficient under the growth conditions used compared with the low-energy nonpolar {011} surfaces. As a consequence, InAs growth now takes place almost only on these high-energy surfaces, except for the Au-catalysed vapour-solid-solid (VSS) growth. As the growth continues the flakes reaches a triangular shape with surfaces that, judging from the scanning electron microscopy (SEM) images, most likely are {133}B surfaces having an angle of 76.78 relative to the (100) substrate surface (FIG. 7c). With increasing growth times the epitaxial vapour-solid (VS) InAs growth on the high-energy {133}B surfaces causes them to continue upward and outward, thereby increasing the flake width. Average widths at the flake base have been observed to be between 350 nm to 500 nm. These widths are depending upon the specific growth conditions. For longer growth times the height of the flake reaches a point, likely connected with the surface diffusion length of the In, where the growth rate on the lower part of the two {133}B surfaces starts to increase. This results in the {133}B surfaces slowly changing towards becoming the vertical nonpolar {011} surfaces. At the same time the Au-catalysed growth at the top of the flake continues, thereby causing the high-energy B surfaces still to exist at the top of the plate. The final shape of the flake is reached after a few micrometres of vertical growth, and here the top of the flake is formed by the still continuing VSS growth combined with the two arsenic-terminated surfaces connecting the Au-In eutectic particle to the lower sides of the flake, which are close to being the nonpolar {011} surfaces (FIG. 7d). This final flake shape has been observed to exist for growth heights up to at least 15 µm for growths using As₂. The growth times used to grow the flakes range between 30 and 120 minutes.

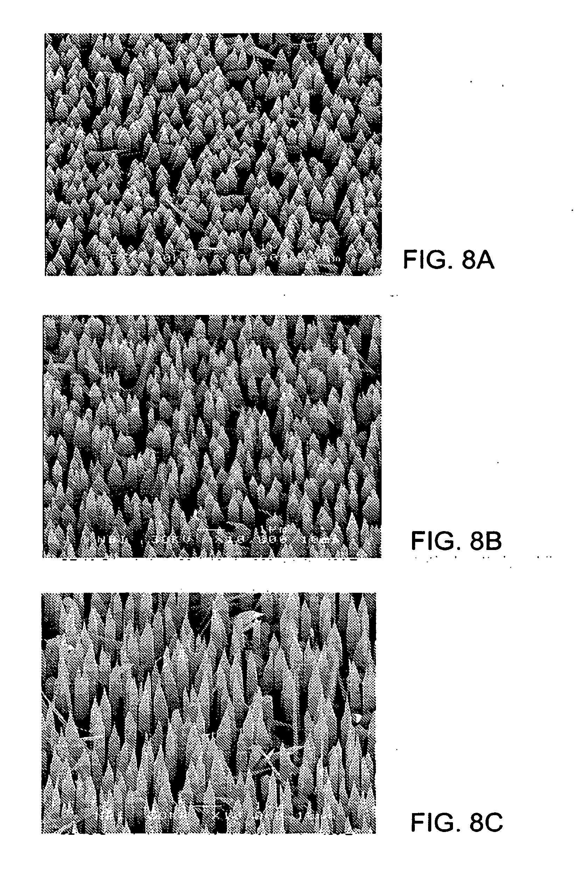

FIGS. 8A to 8C illustrate inclined SEM images of InAs flakes grown by means of MBE on the (100) face of a GaAs-substrate at different V/III-BEP-ratio and different substrate temperature. The V/III-ratio has been changed by changing the BEP of the As₄-bedm. The images are obtained at 30 KV with a magnification of 10,000. The scale bar indicates the extension of 1 µm.

The InAs flakes of FIG. 8A were grown with a V/III-BEP-ratio of 4.3 using a beam equivalent pressure (BEP) of 4.7×10⁻⁴Pa (3.6×10⁻⁶ torr) for As₄, and a BEP of 10.7×10⁻⁵Pa (8.3×10⁻⁷ torr) for In. The substrate was held at a temperature of approximate 420°C and the growth time was 1.5 hours.

The InAs flakes of FIG. 8B were grown with a V/III-BEP-ratio of 5.4 using a beam equivalent pressure (BEP) of 5.9×10⁻⁴Pa (4.5×10⁻⁶ torr) for As₄, and a BEP of 10.8×10⁻⁵ (8.4×10⁻⁷ torr) for In. The substrate was held at a temperature of approximate 420 °C and the growth time was 1.5 hours.

The InAs flakes of FIG. 8C were grown with a V/III-BEP-ratio of 6.5 using a beam equivalent pressure (BEP) of 6.9×10⁻⁴Pa (45.3×10⁻⁶) torr for As₄, and a BEP of 10.6×10⁻⁵Pa (8.2×10⁻⁷torr) for In. The substrate was held at a temperature of approximate 410 °C and the growth time was 1.5 hours.

The images illustrate that the individual flake structure as well as the overall ensemble properties change with changed growth parameters or conditions. Generally, at lower substrate temperatures and lower V/III-BEP-ratios, the flake density is higher than for higher temperatures and V/III-BEP-ratios. Moreover, also a higher degree of wide flake shapes are observed for lower substrate temperatures and lower V/III-BEP-ratios, than for flakes grown at higher temperatures and WIII-BEP-ratios.

Suitable V/III-BEP-ratios are found between 3.5 and 5.5, and suitable substrate temperatures are found between 350 °C and 450 °C. However, it is to be understood that the invention is not limited to these ranges, since appropriate structures may also be found outside these ranges.

The flakes illustrated in FIGS. 2-6, 8, 14 were grown using As₄, but growths using As₂ is also possible. When using a beam of As₂ the thickness of the flakes was seen to increase with growth time as compared to As₄ growth, moreover for the same amount of deposited Au, the thicknesses of the flakes are observed to be larger for the As₂-grown samples than for those grown using As₄, this agrees with the higher incorporation coefficient of As₂ on {011} surfaces.

FIG. 9 is a schematic illustration of an embodiment of a flake having an np-junction 93. The np-junction is provided by having a semiconducting structure comprising an n-region having an n-conductivity and a p-region having a p-conductivity, the regions forming an np-junction. The placement of the n-region and the p-region is illustrated by cross-sections. A first cross-section as denoted by the reference numeral 91 and a second perpendicular cross-section as denoted by reference numeral 92. A semiconducting structure as generally shown by FIG. 9 may be provided in a number of ways.

In an embodiment, the differences in growth using As₄ and As₂ may be used to grow a flake having a general structure as illustrated in FIG. 9. A schematic illustration of this embodiment is provided in FIG. 10.

FIG. 10 illustrates an embodiment, where the flakes are grown with a first growth stage and at least a second growth stage. In a first growth stage the inner semiconducting structure 100 is grown with a first conductivity (e.g. p-conductivity) using As₄. This results in flakes with a significant larger width than thickness (here seen in a cross-section corresponding to the cross-section denoted 91 in FIG. 9). Once an appropriate size and shape distribution has been obtained, i.e. after a given time of growth, further growth is continued using As₂. In the second growth stage the outer semiconducting structure 101 is grown with a second conductivity (e.g. n-conductivity) using As₂. This results in flakes with a shell of n-conductivity, np-junctions 102 are thereby obtained inside the flakes. For the resulting semiconducting structures the width-to-thickness ratio is smaller than for the width-to-thickness ratio of the inner structures, grown by As₄. However, at least the part of the semiconducting structures constituted by the inner structure (the As₄ grown structure) is of a general plate shape where, at a section positioned at the lower half of the structure, the width is substantially larger than the thickness. That is, at least the inner structure has a flake shape as discussed in connection with the SEM images.

In an embodiment, a p-type semiconducting structure is grown on top of which a donor material is deposited. The system may be heated to a temperature so that the donor material migrates into the shell region or surface region of the p-type semiconducting structure thereby providing donor impurities and changing the conductivity type to n-type. An np-junction is thereby provided. Also multilayer deposition followed by heating may be used to provide an n-type region or shell. For example an annealed multilayer of Ge, Au and Ni may be used to provide an n-type region covering a p-type flake.

In an embodiment the donor material may be deposited by means of spin-on doping.

In an embodiment the donor material may be sputtered into to the shell region of the semiconducting structure. The donor material is thereby provided in the form of donor ions.

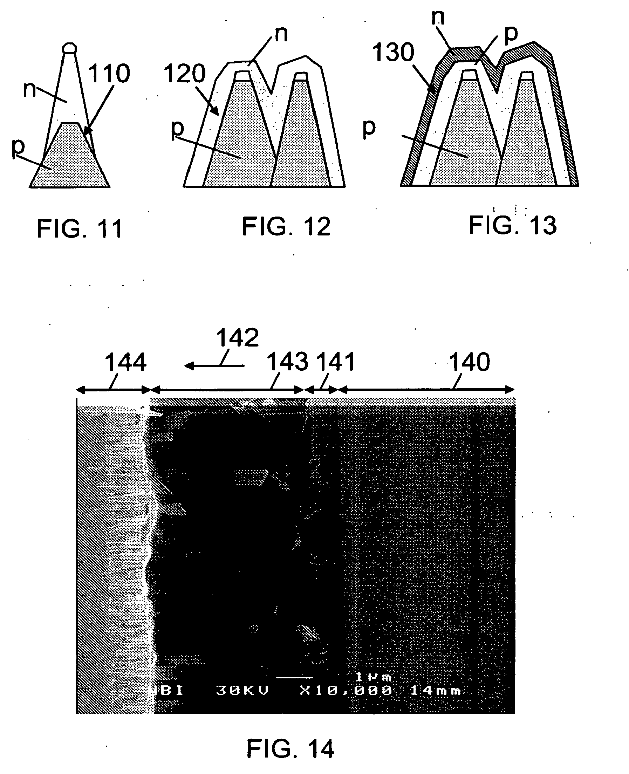

FIG. 11 is a schematic illustration of an embodiment of a flake having an np-junction 110. The np-junction is provided by growing a first part of the semiconducting structure with a p-type material and a second part of the semiconducting structure with an n-type material. This may be obtained by changing the growth material, e.g. in the MBE the material of the beam may be changed during growth. This process may be continued thereby forming multiple n-regions having an n-conductivity and multiple p-regions having a p-conductivity, so that multiple np-junction are formed.

Instead of changing the growth material during growth, the p-type semiconducting structure may be grown in a first step, afterwhich an n-type material is deposited onto the semiconducting structure, a schematic embodiment is illustrated in FIG. 12. Separate structures of different materials are provided so that a semiconducting structure of p-conductivity is abutting a region or coating having an n-conductivity, so that the interface between the semiconducting structures and the region is forming the np-junction 120.

Instead of changing the growth material during growth, the p-type semiconducting structure may be grown in a first step, afterwhich an n-type material is deposited onto the semiconducting structure, a schematic embodiment is illustrated in FIG. 12. Separate structures of different materials are provided so that a semiconducting structure of p-conductivity is abutting a region or coating having an n-conductivity, so that the interface between the semiconducting structures and the region is forming the np-junction 120.

FIG. 13 illustrates an embodiment, where semiconducting structures of p-conductivity are provided and onto which a semiconductor material of the same conductivity is provided. Onto the first layer of semiconductor material of p-conductivity a semiconductor material of different conductivity, or n-conductivity, is provided, so that the semiconducting structure comprises or supports a region having n-conductivity and a region having p-conductivity forming an np-junction 130.

The inner part of the semiconducting structure may in an embodiment be an p-type InAs flake. The first layer may be a p-type GaAs layer and the second layer may be an n-type GaAs.

In the schematic embodiments illustrated in FIGS. 9-13 the np-junction are provided over the entire semiconducting structure. However, part of the semiconducting structure may be covered by a filler material before providing the np-junction, so that only a part of the semiconducting structure is covered by or supporting an np-junction.

Above, reference has been made in the Figures to specific regions of n-conductivity and p-conductivity. It is to be understood that regions of n-conductivity may be interchanged with regions of p-conductivity and vice versa.

FIG. 14 illustrates an SEM image of InAs flakes grown by MBE on a GaAs-substrate where the flakes are embedded in an SU-8 filler. The image is obtained at 30 KV with a magnification of 10,000. The scale bar indicates the extension of 1 µm. The image is obtained in cross-section.

A bulk GaAs is used as the supporting substrate 140, and on top of the GaAs the InAs flakes are provided. In connection with the growth a thin layer 141 of bulk InAs has occurred. The flakes are protruding in the direction marked 142. The flakes are partly embedded in an SU-8 filler 143, and the top of the flakes are protruding out of the filler 144. The flakes protruding out of the filler have been covered with a thin layer of Au. The part of the flakes which are embedded by the SU-8 filler cannot clearly be seen due to the presence of the filler material.

The filler material has been provided onto the flakes be dripping a small drop of liquid SU-8 onto the substrate followed by spinning of the system with 2000 rpm in 55 sec. The system is hardened by baking it on a hotplate at 115 °C in 105 sec.

From inspection of the SEM images no or only very few holes or imperfections of the filler material have been found, revealing a very good penetration of the SU-8 material into the spaces between the flakes.

The semiconducting structures as shown in the Figures are grown in an MBE system. In a specific exemplary embodiment, the growth has been done as described in the following.

A solid source Varian GEN II MBE system with a growth chamber base pressure in the low 10⁻¹¹ torr range was used. The system used As₄ as the group V material and In as the group III material, both materials had an MBE grade purity.

Prior to growing the semiconducting structures, a GaAs (100) substrate in a form ready for epitaxial overgrowth was received from the producer.

The substrate was mounted in a substrate holder and loaded into the MBE system load lock where it was degassed at 200 °C for approximately 2 hours. The pressure in the load lock was then allowed to recover to the 1.33×10⁻⁵Pa (10⁻⁷ torr) range and the substrate subsequently transferred to the growth chamber, via a buffer chamber.

In the growth chamber the substrate was constantly exposed to an As₄ flux with a Beam Equivalent Pressure (BEP) of approximately 1.56×10⁻³Pa (1.2×10⁻⁵ torr). The substrate was heated to around 560 °C for 10 minutes before a thin layer of Au was deposited onto it. The Au deposition was done by heating a 16cc crucible to 1350 °C and then opening the shutter in front of it for 150 seconds. In this process between 0.5-2 nm Au was deposited on the substrate surface, the thickness estimate is however somewhat uncertain.

Still in the growth chamber and in an As₄ flux the substrate was kept at the around 560 °C for 10 minutes after Au deposition to allow the Au to form the nanosized growth catalyst particles. After 10 minutes the substrate temperature was lowered to the growth temperature and the growth initiated by opening the In shutter. The growth took up to a few hours after which the In shutter was closed and the substrate temperature was lowered to 200 °C still in an As₄ flux.

When the substrate temperatures reached 200 °C the substrate was removed from the MBE system.

The substrate temperatures mentioned above have been converted from the temperature measured with a thermocouple at the substrate growth position in the MBE system to what, to the best of our knowledge, is the real substrate temperature corrected for the thermocouple error. The substrate temperature measured with the thermocouple in the growth chamber during Au deposition was 640 °C. The substrate temperature measured with the thermocouple during flake growth was 470 °C.

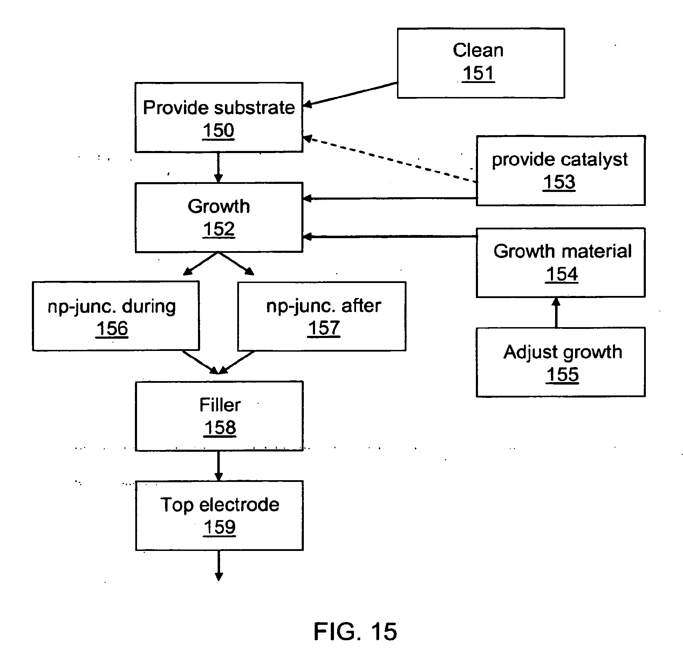

FIG. 15 illustrates a flow diagram of a general procedure of fabricating an optical device in accordance with embodiments of the present invention.

In a first step, a substrate is provided. The substrate may in a prior step be grown, cut and polished, cleaved, etc. The substrate may be provided in a final state so that no additional cleaning is needed, however typically, the substrate needs to be cleaned 151. For example it may be cleaned by means of annealing or degassing, by means of sputter-annealing cycles, by means of exposure to specific gases, e.g. followed by annealing or sputter-annealing cycles, by means of flushing with specific gases, possible while heating the substrate, by means of wet etching, such as etching in HF followed by rinsing in clean water or alcohol and dried in a flow of nitrogen.

As an example, a GaAs (100) substrate may be degassed in a number of steps at a temperature of a few hundred degrees, such as 200 °C in a first background pressure and subsequently at 400 °C in a second, typically lower, background pressure, for a few hours, such as 2 to 4 hours.

The semiconducting structures may next be grown on the substrate 122, e.g. by means of VLS growth.

In the VLS growth mechanism, nucleation centres in the form of catalytic particles are first deposited onto the substrate 153. Typically Au particles are provided, other suitable catalytic particle include but are not limited to Pt, Pd, Ni and Fe. A quantity corresponding to a few nm, such as between 0.1-5 nm may be deposited. The substrate may e.g. be heated-for a specific time, such as 5 to 20 minutes, for redistribution, resizing or reshaping of the catalytic particles. Also, the substrate may be maintained at an elevated temperature during deposition.

Typically, the catalytic particles may be provided by vapour deposition of the particles, e.g. from heating a crucible. Alternatively means include, but are not limited to, deposition of colloid particles and nano-imprint lithography techniques. Both colloids and nano-imprint lithography may be done before the sample is transferred into the growth chamber.

The substrate is typically maintained at a specific temperature while growing the semiconducting structures. A typical growth temperature ranges from room temperature to 800 °C. For example, InAs semiconducting structures may be grown by exposing the substrate to an As₄ beam and an In beam at a substrate temperature of 400 to 450 °C, such as 420 °C. However, InAs semiconducting structures may also be grown by exposing the substrate to an As₂ beam and an In beam, however, the substrate temperature and/or V/III ratio or other parameters may be different than for an As₄ beam.

The substrate is exposed to the growth material 154, typically in the form of a beam or vapour, for a period of time, such as from few minutes to several hours. During growth the substrate is exposed to fluxes of relevant materials, the growth material may e.g. be incorporated in a carrier gas. The specific sizes of the different fluxes are adjusted 155, to achieve a specific ratio of the impinging species. As an example, for InAs growth a V/III ratio between 3.5 and 5.5may be set. Also the specific materials may be adjusted or changed during the growth.

The semiconducting structures are provided with np-junctions, this may be obtained in different ways. In an embodiment, the np-junction is provided during the growth 156 e.g. by controlling and adjusting the composition of the flux, e.g. by introducing a new species at a certain point in time, and possibly shutting off a given other species. In another embodiment, the np-junction is provided after the semiconducting structure have been grown 157, for example by means of doping or deposition of additional layers.

A filler material may in a next step 158 be provided onto the semiconducting structures, and a top electrode 159 may be provided onto the filler material.

In additional steps, the electrodes may be contacted to electronic circuitry, a housing may be provided, etc.

Moreover, additional steps or alternative steps may be provided. For example in an embodiment where the substrate is insulating or insufficiently conducting, a conductor layer may be deposited onto the combined system of semiconductor structures and substrate. After the deposition may an etch step be performed. Etching of the layer on the semiconducting structures will typically be at a higher rate than etching the layer deposited on the substrate. Thus by stopping the etch process when the semiconducting structures have been freed from the deposited material, a layer of the material may still be present at the substrate, thereby providing an electrical contact to the structures.

Although the present invention has been described in connection with the specified embodiments, it should not be construed as being in any way limited to the presented examples. The scope of the present invention is to be interpreted in the light of the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. An optical device (1) comprising:
a first electrode (4);
a second electrode (5), the first and/or second electrode (4, 5) being transmissive for radiation in a first wavelength range;
an active element (3) having an n-p junction disposed between the first and second electrodes (4, 5), the active element (3) comprising a plurality of semiconducting structures (6) grown in a lengthwise direction out of a planar surface on the first electrode (4) and being in electrical contact with the first and second electrodes (4, 5);
**characterised in that**:
each semiconducting structure (6) comprises a plate-like portion in which a width of the structure in a first direction across the planar surface is greater than a thickness of the structure in a second direction across the planar surface that is orthogonal to the first direction, and wherein the plate-like portion includes a tapering portion in which the width of the structure decreases as it approaches the second electrode (5).

2. A device according to claim 1, wherein the planar surface is a face of a crystalline surface and the lengthwise direction is substantially perpendicular to that surface.

3. A device according to claim 2, wherein the crystalline surface is an (1 0 0) face of a crystalline substrate, and the first direction is the [0 -1 1] direction and the second direction is the [0 -1 -1] direction of that substrate.

4. A device according to claim 3, wherein the tapering portion has sloping surfaces facing substantially in the [1 3 3]B direction.

5. A device according to any preceding claim, where the first electrode (4) and/or each semiconducting structure (6) is a group V/III semiconductor, a group VI/II semiconductor, a group IV semiconductor or an alloy thereof.

6. A device according to any preceding claim, where the first electrode (4) and/or the second electrode (5) is a transparent conductor.

7. A device according to any preceding claim, where the first electrode (4) and/or the second electrode (5) comprises a layered substrate having two or more layers.

8. A device according to any preceding claim, where the semiconducting structure (6) has an absorbance in the visual and/or infrared range of at least 70%.

9. A device according to any preceding claim, wherein the active element (3) comprises an n-region having an n-type conductivity and a p-region having a p-type conductivity, the n-region and p-region meeting at the n-p junction, and when the semiconducting structures (6) are one of n-conductivity or p-conductivity and support semiconductor material of the other conductivity to form the n-p junction.

10. A device according to any preceding claim, wherein each semiconducting structure (6) includes an inner element of a first semiconductor material (100), the inner element having the plate-like portion and the tapering portion, and a shell element of a second semiconductor material (101), the shell element being formed over the inner element.

11. A device according to claim 10, wherein the first and second semiconductor materials have different conductivities, whereby the semiconducting structures comprise multiple n-regions having an n-conductivity and multiple p-regions having a p-conductivity, to form multiple n-p junctions.

12. A device according to claim 10, wherein the second semiconductor material (101) is a different compound from the first semiconductor material (100).

13. A solar cell, radiation detector or light emitter comprising a device according to any preceding claim.

14. A method of fabricating an optical device, the method comprising:
forming a plurality of nucleation centres on a planar surface on a first electrode;
depositing material to grow a plurality of semiconducting structures at the nucleation centres in a lengthwise direction out of the planar surface on the first electrode; and
forming a second electrode such that the semiconducting structure are disposed between and in electrical contact with the first and second electrodes,
**characterised in that**:
growing each semiconducting structure includes:
forming a plate-like portion in which a width of the structure in a first direction across the planar surface is greater than a thickness of the structure in a second direction across the planar surface that is orthogonal to the first direction, and
forming a tapering portion of the plate-like portion in which the width of the structure decreases as it approaches the second electrode.

15. A method according to claim 14, wherein the deposited material is crystalline, and growing each semiconducting structure comprises:
a catalysed vapour-liquid-solid (VLS) or vapour-solid-solid (VSS) process in the lengthwise direction at the nucleation centre, and
an epitaxial vapour-solid (VS) process on a pair of surfaces on opposite sides of the nucleation centre, each surface being inclined to the planar surface and extending further in the first direction than in the second direction.

16. A method according to claim 14 or 15, comprising depositing an electrically insulating filler material on the semiconductor structures to form a solid active element before forming the second electrode on the active element.

17. A method according to any one of claims 14 to 16, wherein depositing material to grow the plurality of semiconducting structures comprises depositing a first semiconductor material to form an inner element, the inner element having the plate-like portion and the tapering portion, and then depositing a second semiconductor material to form a shell element, the shell element being formed over the inner element.

18. A method according to any one of claims 14 to 17, wherein the semiconducting structures are one of n-conductivity or p-conductivity and the method includes depositing a support semiconductor material of the other conductivity to form the n-p junction after the semiconducting structures are formed.

19. A method according to any one of claims 14 to 18 including, after the semiconducting structures are grown, doping the deposited material to form a doped region in each semiconducting structure.

## Patentansprüche

1. Optische Vorrichtung (1), umfassend:
eine erste Elektrode (4);
eine zweite Elektrode (5), wobei die erste und/oder die zweite Elektrode (4, 5) für Strahlung in einem ersten Wellenlängenbereich transmissiv sind;
ein aktives Element (3) mit einem n-p-Übergang, der zwischen der ersten und der zweiten Elektrode (4, 5) ausgebildet ist, wobei das aktive Element (3) eine Vielzahl von Halbleiterstrukturen (6) umfasst, deren Wachstum in Längsrichtung aus einer planaren Oberfläche auf der ersten Elektrode (4) hinausgerichtet ist und in elektrischem Kontakt mit der ersten und der zweiten Elektrode (4, 5) stehen;
**dadurch gekennzeichnet, dass**
jede Halbleiterstruktur (6) einen plattenartigen Teil umfasst, worin die Breite der Struktur in einer ersten Richtung über die planare Oberfläche hinweg größer ist als die Dicke der Struktur in einer zweiten Richtung über die planare Oberfläche hinweg, die im rechten Winkel zur ersten Richtung steht, und worin der plattenartige Teil einen sich verjüngenden Teil umfasst, in welchem die Breite der Struktur abnimmt, je mehr sie sich der zweiten Elektrode (5) annähert.

2. Vorrichtung nach Anspruch 1, worin die planare Oberfläche eine Kristallfläche einer kristallinen Oberfläche ist und die Längsrichtung im Wesentlichen senkrecht auf diese Oberfläche ist.

3. Vorrichtung nach Anspruch 2, worin die kristalline Oberfläche eine (1 0 0)-Kristallfläche eines kristallinen Substrats ist, die erste Richtung die [0 -1 1]-Richtung und die zweite Richtung die [0 -1 -1]-Richtung dieses Substrats ist.

4. Vorrichtung nach Anspruch 3, worin der sich verjüngende Teil geneigte Oberflächen aufweist, die im Wesentlichen in die [1 3 3]B-Richtung weisen.

5. Vorrichtung nach einem der vorangegangenen Ansprüche, worin die erste Elektrode (4) und/oder jede Halbleiterstruktur (6) ein Halbleiter der Gruppe V/III, ein Halbleiter der Gruppe VI/II, ein Halbleiter der Gruppe IV oder eine Legierung davon sind.

6. Vorrichtung nach einem der vorangegangenen Ansprüche, worin die erste Elektrode (4) und/oder die zweite Elektrode (5) ein transparenter Halbleiter sind.

7. Vorrichtung nach einem der vorangegangenen Ansprüche, worin die erste Elektrode (4) und/oder die zweite Elektrode (5) ein geschichtetes Substrat mit zwei oder mehreren Schichten umfassen.

8. Vorrichtung nach einem der vorangegangenen Ansprüche, worin die Halbleiterstruktur (6) eine Absorption im sichtbaren und/oder im Infrarotbereich von zumindest 70 % aufweist.

9. Vorrichtung nach einem der vorangegangenen Ansprüche, worin das aktive Element (3) eine n-Zone mit Leitfähigkeit des Typs n und eine p-Zone mit Leitfähigkeit des Typs p umfasst, wobei die n-Zone und die p-Zone am n-p-Übergang aneinandergrenzen, und worin die Halbleiterstrukturen (6) solche mit n-Leitfähigkeit oder p-Leitfähigkeit sind und Halbleitermaterial mit der jeweils anderen Leitfähigkeit tragen, um den n-p-Übergang auszubilden.

10. Vorrichtung nach einem der vorangegangenen Ansprüche, worin jede Halbleiterstruktur (6) ein Innenelement aus einem ersten Halbleitermaterial (100), wobei das Innenelement den plattenartigen Teil und den sich verjüngenden Teil aufweist, und ein Schalenelement aus einem zweiten Halbleitermaterial (101) umfasst, wobei das Schalenelement über dem Innenelement ausgebildet ist.

11. Vorrichtung nach Anspruch 10, worin das erste und das zweite Halbleitermaterial unterschiedliche Leitfähigkeit aufweisen, wodurch die Halbleiterstrukturen mehrere n-Zonen mit n-Leitfähigkeit und mehrere p-Zonen mit p-Leitfähigkeit umfassen, um mehrere n-p-Übergänge auszubilden.

12. Vorrichtung nach Anspruch 10, worin das zweite Halbleitermaterial (101) eine andere Verbindung ist als das erste Halbleitermaterial (100).

13. Solarzelle, Strahlungsdetektor oder Lichtemitter, umfassend eine Vorrichtung nach einem der vorangegangenen Ansprüche.

14. Verfahren zur Herstellung einer optischen Vorrichtung, wobei das Verfahren Folgendes umfasst:
das Ausbilden einer Vielzahl von Keimbildungszentren an einer planaren Oberfläche auf einer ersten Elektrode;
das Abscheiden von Material, um in den Keimbildungszentren eine Vielzahl von Halbleiterstrukturen in Längsrichtung aus der planaren Oberfläche auf der ersten Elektrode wachsen zu lassen; und
das Ausbilden einer zweiten Elektrode, so dass die Halbleiterstruktur zwischen der ersten und der zweiten Elektrode ausgebildet ist und in elektrischem Kontakt mit diesen steht,
**dadurch gekennzeichnet, dass**
das Züchten jeder Halbleiterstruktur Folgendes umfasst:
das Ausbilden eines plattenartigen Teils, worin die Breite der Struktur in einer ersten Richtung über die planare Oberfläche hinweg größer ist als die Dicke der Struktur in einer zweiten Richtung über die planare Oberfläche hinweg, die im rechten Winkel zur ersten Richtung steht, und
das Ausbilden eines sich verjüngenden Teils des plattenartigen Teils, worin die Breite der Struktur abnimmt, je mehr sie sich der zweiten Elektrode annähert.

15. Verfahren nach Anspruch 14, worin das abgeschiedene Material kristallin ist und das Züchten jeder Halbleiterstruktur Folgendes umfasst:
ein katalysiertes Dampf-Flüssigkeit-Feststoff- (VLS-) oder Dampf-Feststoff-Feststoff- (VSS-) Verfahren in Längsrichtung im Keimbildungszentrum, und
ein epitaxiales Dampf-Feststoff- (VS-) Verfahren auf einem Oberflächenpaar an entgegengesetzten Seiten des Keimbildungszentrums, wobei jede Oberfläche zur planaren Oberfläche hin geneigt ist und sich in die erste Richtung weiter erstreckt als in die zweite Richtung.

16. Verfahren nach Anspruch 14 oder 15, umfassend das Abscheiden eines elektrisch isolierenden Füllmaterials auf den Halbleiterstrukturen, um ein festes, aktives Element auszubilden, bevor die zweite Elektrode auf dem aktiven Element ausgebildet wird.

17. Verfahren nach einem der Ansprüche 14 bis 16, worin das Abscheiden von Material, um die Vielzahl von Halbleiterstrukturen zu züchten, das Abscheiden eines ersten Halbleitermaterials zum Bilden eines Innenelements, wobei das Innenelement den plattenartigen Teil und den sich verjüngenden Teil umfasst, und das anschließende Abscheiden eines zweiten Halbleitermaterials zum Bilden eines Schalenelements umfasst, wobei das Schalenelement über dem Innenelement ausgebildet ist.

18. Verfahren nach einem der Ansprüche 14 bis 17, worin die Halbleiterstrukturen solche mit n-Leitfähigkeit oder p-Leitfähigkeit sind und das Verfahren das Abscheiden eines Trägerhalbleitermaterials mit der jeweils anderen Leitfähigkeit umfasst, um den n-p-Übergang auszubilden, nachdem die Halbleiterstrukturen ausgebildet wurden.

19. Verfahren nach einem der Ansprüche 14 bis 18, das nach dem Züchten der Halbleiterstrukturen das Dotieren des abgeschiedenen Materials zur Bildung einer dotierten Zone in jeder Halbleiterstruktur umfasst.

## Revendications

1. Dispositif optique (1) comprenant :
une première électrode (4) ;
une seconde électrode (5), la première et/ou seconde électrode (4, 5) étant transmissives du rayonnement dans une première plage de longueurs d'onde ;
un élément actif (3) ayant une jonction n-p disposée entre les première et seconde électrodes (4, 5), l'élément actif (3) comprenant une pluralité de structures semi-conductrices (6) mises à croître dans le sens de la longueur hors d'une surface plane sur la première électrode (4) et étant en contact électrique avec les première et seconde électrodes (4, 5) ;
**caractérisé en ce que** :
chaque structure semi-conductrice (6) comprend une portion de type plaque dans laquelle une largeur de la structure dans une première direction à travers la surface plane est plus grande qu'une épaisseur de la structure dans une seconde direction à travers la surface plane qui est orthogonale à la première direction, et où la portion de type plaque inclut une portion se rétrécissant dans laquelle la largeur de la structure diminue à mesure qu'elle s'approche de la seconde électrode (5).

2. Dispositif selon la revendication 1, dans lequel la surface plane est une face d'une surface cristalline et le sens de la longueur est sensiblement perpendiculaire à cette surface.

3. Dispositif selon la revendication 2, dans lequel la surface cristalline est une face (1 0 0) d'un substrat cristallin, et la première direction est la direction [0 -1 1] et la seconde direction est la direction [0 -1 -1] de ce substrat.

4. Dispositif selon la revendication 3, dans lequel la portion se rétrécissant comporte des surfaces inclinées regardant sensiblement dans la direction [1 3 3]B.

5. Dispositif selon l'une quelconque des revendications précédentes, dans lequel la première électrode (4) et/ou chaque structure semi-conductrice (6) sont un semi-conducteur du groupe V/III, un semi-conducteur du groupe VI/II, un semi-conducteur du groupe VI ou l'un de leurs alliages.

6. Dispositif selon l'une quelconque des revendications précédentes, dans lequel la première électrode (4) et/ou la seconde électrode (5) sont un conducteur transparent.

7. Dispositif selon l'une quelconque des revendications précédentes, dans lequel la première électrode (4) et/ou la seconde électrode (5) comprennent un substrat en couches comportant deux couches ou plus.

8. Dispositif selon l'une quelconque des revendications précédentes, dans lequel la structure semi-conductrice (6) a une absorbance dans la plage visuelle et/ou infrarouge d'au moins 70 %.

9. Dispositif selon l'une quelconque des revendications précédentes, dans lequel l'élément optique (3) comprend une région n ayant une conductivité de type n et une région p ayant une conductivité de type p, la région n et la région p se rencontrant à la jonction n-p, et où les structures semi-conductrices (6) sont de conductivité n ou de conductivité p et supportent un matériau semi-conducteur d'une autre conductivité pour former la jonction n-p.

10. Dispositif selon l'une quelconque des revendications précédentes, dans lequel chaque structure semi-conductrice (6) inclut un élément interne d'un premier matériau semi-conducteur (100), l'élément interne comportant la portion de type plaque et la portion se rétrécissant, et un élément de coque d'un second matériau semi-conducteur (101), l'élément de coque étant formé par-dessus l'élément interne.

11. Dispositif selon la revendication 10, dans lequel le premier et le second matériau semi-conducteur ont des conductivités différentes, moyennant quoi les structures semi-conductrices comprennent de multiples régions n ayant une conductivité n et de multiples régions p ayant une conductivité p, pour former de multiples jonctions n-p.

12. Dispositif selon la revendication 10, dans lequel le second matériau semi-conducteur (101) est un composé différent du premier matériau semi-conducteur (100).

13. Pile solaire, détecteur de rayonnement ou émetteur de lumière comprenant un dispositif selon l'une quelconque des revendications précédentes.

14. Procédé de fabrication d'un dispositif optique, le procédé comprenant les étapes consistant à :
former une pluralité de centres de nucléation sur une surface plane sur une première électrode ;
déposer un matériau pour faire croître une pluralité de structures semi-conductrices au niveau des centres de nucléation dans un sens de la longueur hors de la surface plane sur la première électrode ; et
former une seconde électrode de telle sorte que les structures semi-conductrices soient disposées entre et en contact électrique avec les première et seconde électrodes,
**caractérisé en ce que** :
la croissance de chaque structure semi-conductrice comprend les étapes consistant à :
former une portion de type plaque dans laquelle une largeur de la structure dans une première direction à travers la surface plane est plus grande qu'une épaisseur de la structure dans une seconde direction à travers la surface plane qui est orthogonale à la première direction, et
former une portion se rétrécissant de la portion de type plaque dans laquelle la largeur de la structure diminue à mesure qu'elle s'approche de la seconde électrode.

15. Procédé selon la revendication 14, dans lequel le matériau déposé est cristallin, et la croissance de chaque structure semi-conductrice comprend :
un procédé vapeur-liquide-solide (VLS) catalysé ou vapeur-solide-solide (VSS) dans le sens de la longueur au niveau du centre de nucléation, et
un procédé vapeur-solide (VS) épitaxial sur une paire de surfaces sur des côtés opposés du centre de nucléation, chaque surface étant inclinée par rapport à la surface plane et s'étendant davantage dans la première direction que dans la seconde direction.

16. Procédé selon la revendication 14 ou 15, comprenant le dépôt d'un matériau de charge électriquement isolant sur les structures semi-conductrices pour former un élément actif solide avant de former la seconde électrode sur l'élément actif.

17. Procédé selon l'une quelconque des revendications 14 à 16, dans lequel le dépôt de matériau pour faire croître la pluralité de structures semi-conductrices, comprend le dépôt d'un premier matériau semi-conducteur pour former un élément interne, l'élément interne comportant la portion de type plaque et la portion se rétrécissant, puis le dépôt d'un second matériau semi-conducteur pour former un élément de coque, l'élément de coque étant formé par-dessus l'élément interne.

18. Procédé selon l'une quelconque des revendications 14 à 17, dans lequel les structures semi-conductrices sont de conductivité n ou de conductivité p et le procédé inclut le dépôt d'un matériau semi-conducteur de support de l'autre conductivité pour former la jonction n-p après formation des structures semi-conductrices.

19. Procédé selon l'une quelconque des revendications 14 à 18, incluant, après croissance des structures semi-conductrices, le dopage du matériau déposé pour former une région dopée dans chaque structure semi-conductrice.
